(19) **Europäisches Patentamt / European Patent Office / Office européen des brevets**

(11) **EP 0 978 885 B1**

(12) **EUROPEAN PATENT SPECIFICATION**

(45) Date of publication and mention
of the grant of the patent:
**26.03.2008 Bulletin 2008/13**

(51) Int Cl.:
*H01L 39/12* $^{(2006.01)}$    *H01L 39/24* $^{(2006.01)}$

(21) Application number: **99115430.3**

(22) Date of filing: **04.08.1999**

(54) **Superconductor with high trapped field**

Supraleiter mit hohem remanentem Feld

Supraconducteur à champ piège élevé

(84) Designated Contracting States:
**AT DE GB**

(30) Priority: **06.08.1998 JP 22251898**

(43) Date of publication of application:
**09.02.2000 Bulletin 2000/06**

(73) Proprietors:
• **INTERNATIONAL SUPERCONDUCTIVITY TECHNOLOGY CENTER**
  **Tokyo 105-0004 (JP)**
• **RAILWAY TECHNICAL RESEARCH INSTITUTE**
  **Kokubunji-shi,**
  **Tokyo 185-8540 (JP)**

(72) Inventors:
• **Chikumoto, Noriko,**
  **Int. Superconduct. Tech. Center**
  **Tokyo 105-0023 (JP)**
• **Murakami, Masato,**
  **Int. Superconduct. Tech. Center**
  **Tokyo 105-0023 (JP)**
• **Nagashima, Ken**
  **Kokubunji-shi,**
  **Tokyo 185-8540 (JP)**
• **Mochida, Tadashi,**
  **c/o Tokyo Gas Co., Ltd.**
  **Yokohama-shi,**
  **Kanagawa 230-0045 (JP)**
• **Novak, Wolfgang,**
  **Atominstitut**
  **1020 Wien (AT)**
• **Sauerzopf, Franz,**
  **Atominstitut**
  **1020 Wien (AT)**
• **Weber, Harald,**
  **Atominstitut**
  **1020 Wien (AT)**

(74) Representative: **Goddar, Heinz J. et al**
**FORRESTER & BOEHMERT**
**Pettenkoferstrasse 20-22**
**80336 München (DE)**

(56) References cited:
**WO-A-93/01602**

• **VLCEK B M ET AL: "Flux pinning in YBa/sub 2/Cu/sub 3/O/sub 7- delta / single crystals: neutron irradiation and annealing" PHYS. REV. B, CONDENS. MATTER (USA), PHYSICAL REVIEW B (CONDENSED MATTER), 1 SEPT. 1992, USA, vol. 46, no. 10, 1 September 1992 (1992-09-01), pages 6441-6450, XP002287152 ISSN: 0163-1829**
• **WACENOVSKY M ET AL: "Influence of fast neutron irradiation on critical currents and irreversibility lines in MPMG-processed YBa/sub 2/Cu/sub 3/O/sub 7/ superconductors" CRYOGENICS (UK), CRYOGENICS, 1993, UK, vol. 33, no. 1, 1993, pages 70-76, XP002287153 ISSN: 0011-2275**
• **WEINSTEIN R ET AL: "Very high trapped fields: cracking, creep, and pinning centers" 1996, SINGAPORE, WORLD SCIENTIFIC, SINGAPORE, 1996, pages 625-628, XP009033341 ISBN: 981-02-2715-9**

EP 0 978 885 B1

- NAGASHIMA K ET AL: "Comparative study of magnetic fields trapped in YBa2Cu3Oy and SmBa2Cu3Oy superconducting bulks" MATERIALS SCIENCE AND ENGINEERING B, ELSEVIER SEQUOIA, LAUSANNE, CH, vol. 53, no. 1-2, 1 May 1998 (1998-05-01), pages 164-168, XP004140012 ISSN: 0921-5107
- EGI T ET AL: "High critical-current density of Nd (Ba,Nd)/sub 2/Cu/sub 3/O/sub 7- delta / single crystals" APPL. PHYS. LETT. (USA), APPLIED PHYSICS LETTERS, 16 OCT. 1995, USA, vol. 67, no. 16, 16 October 1995 (1995-10-16), pages 2406-2408, XP002287460 ISSN: 0003-6951
- CHIKUMOTO N ET AL: "Effects of oxygen on the superconducting properties of Nd1+xBa2-xCu3O7-delta (0=<x=<0.4) solid solution" APPLIED SUPERCONDUCTIVITY, PERGAMON PRESS, EXETER, GB, vol. 6, no. 2-5, 5 February 1998 (1998-02-05), pages 163-168, XP004140877 ISSN: 0964-1807
- MURAKAMI M ET AL: "Flux pinning in melt grown LRE123 superconductors" J. LOW TEMP. PHYS. (USA), JOURNAL OF LOW TEMPERATURE PHYSICS, DEC. 1996, PLENUM, USA, vol. 105, no. 5-6, December 1996 (1996-12), pages 1751-1760, XP009033173 ISSN: 0022-2291
- YOO S I ET AL: "RE-Ba-Cu-O for high functional superconducting permanent magnet" MATERIALS SCIENCE AND ENGINEERING B, ELSEVIER SEQUOIA, LAUSANNE, CH, vol. 53, no. 1-2, 1 May 1998 (1998-05-01), pages 203-210, XP004140020 ISSN: 0921-5107
- REN Y ET AL: "Quasi permanent superconducting magnet of very high field" J. APPL. PHYS. (USA), JOURNAL OF APPLIED PHYSICS, 1 JULY 1993, USA, vol. 74, no. 1, 1 July 1993 (1993-07-01), pages 718-719, XP002287154 ISSN: 0021-8979
- FRISCHHERZ M C ET AL: "Defect cascades produced by neutron irradiation in YBa/sub 2/Cu/sub 3/O/sub 7- delta /" PHYSICA C (NETHERLANDS), PHYSICA C, NETHERLANDS, vol. 232, no. 3-4, 1 November 1994 (1994-11-01), pages 309-327, XP009033344 ISSN: 0921-4534

**Description**

The present invention relates to RE-Ba-Cu-O bulk superconductors exhibiting increased critical current density and high electromagnetic force, wherein RE means one or two elements selected from La, Nd, Sm, Eu, Gd, Y, Ho and Dy.

Bulk process technology for preparing RE-Ba-Cu-O type crystals (RE is rare earth elements) has been considerably improved, which makes it possible to produce large RE-Ba-Cu-O oxide bulk superconductors having high critical current density and oriented crystals.

Strong electromagnetic force can be generated by an interaction between such bulk superconductors and outer magnetic field under a contactless condition, which is widely applicable to a magnetic bearing and an electric power storage unit using such a bearing.

On the other hand, a large magnetic field can be trapped by the above mentioned superconductors, and according to recent reports, there have been prepared bulk superconductors of about 1 T at liquid nitrogen temperature (77 K) and higher T values such as 10 T at a lower temperature of 45 K. As RE-Ba-Cu-O bulk superconductors trap a large magnetic field as described above, such superconductors in the same shape and size as a permanent magnet can generate much higher magnetic field than the magnet and attract attention as a novel functional material.

In order to widen an applicable field of these bulk superconductors, it is necessary to further increase electromagnetic force to be generated and furthermore improve a trapped magnetic field. For example, a magnetic field of more than 5 T is necessary to use such superconductors as a magnet for magnetic levitation train which is now practically tested.

In addition, an economic point of view is also important. From such a viewpoint, it is preferable to attain much higher magnetic field at higher temperature, if possible, at liquid nitrogen temperature.

As has been known, it is effective to homogeneously disperse such defects as a fine normal-conductive deposition product, which functions as a pinning center for increasing critical current density while keeping shifted crystal orientation so as to improve electromagnetic force and a trapped magnetic field in superconductors.

Although an effect of various defects such as the normal-conductive deposition product as a pinning center is known, it is quite difficult to distribute these defects homogeneously in the case of a large sized oriented bulk crystal. As a result, there has been few reports either on large sized RE-Ba-Cu-O bulk superconductors in which microdefects are homogeneously distributed to improve properties thereof, or on an epoch-making improvement in performance which can considerably expand applicability thereof.

Conventional large sized RE-Ba-Cu-O bulk superconductors of expected high performance have been generally prepared by a melting process. In this process, a RE-Ba-Cu-O superconductor composition as a starting composition is heated to form a semi-molten state, then seeded with a suitable seed crystal and slowly cooled to prepare a bulk material of shifted crystal orientation. It is also a general practice to provide temperature gradient to superconductors during a solidification step.

The melting process has been originally developed as a technical method which is conducted in the air. Even now, when Y-, Ho- or Dy- containing superconductors (i.e., RE-Ba-Cu-O type superconductors wherein RE is Y, Ho or Dy) are prepared, a corresponding starting composition is generally subjected to melt-solidification in the air, while in the case of La-, Nd-, Sm-, Eu- or Gd-containing superconductors (i.e., RE-Ba-Cu-O superconductor wherein RE is La, Nd, Sm, Eu or Gd), there has been recently developed technique for conducting melt-solidification of a starting composition under a condition of lower oxygen partial pressure, which is greatly expected to improve performance of large sized superconductors. The reason why is that clusters of slightly higher RE concentration and lower critical temperature compared with a parent phase are spontaneously and finely dispersed in the parent phase, which functions as an effective pinning center to result in relatively high critical current density at high temperature, when such solidification is carried out under a condition of lower oxygen partial pressure.

On the other hand, a melting process in which a RE-Ba-Cu-O bulk superconductor is prepared, wherein RE is one or more than two elements selected from La, Nd, Sm, Eu, Gd, Y, Ho or Dy, it has been found that, when a starting composition is melt-solidified, an initial composition thereof is set in advance to a $RE_2BaCuO_5$ phase (so-called RE211 phase)-rich side, or to a $RE_4Ba_2Cu_2O_{10}$ phase (so-called RE422 phase)-rich side in the case of RE = La or Nd, to successfully yield structure in which the RE211 or RE 422 phase is finely dispersed in a superconductive $REBa_2Cu_3O_y$ (RE123) phase. Using the above mentioned structure control technique, it has been also possible to prepare superconductors in which relatively higher critical current density is achieved.

However, the above mentioned processes are not enough to provide large sized RE--Ba-Cu-O bulk superconductors satisfactorily usable as a magnet for magnetic levitation train, etc. in which a sufficiently high magnetic field can be obtained at a relatively low temperature.

Electromagnetic force or coercive force (F) of a bulk superconductor is represented by the following formula:

$$F = AJ_C\,d$$

wherein A is a proportional constant depending on the shape of superconductor, $J_c$ is critical current density and d is diameter or size of superconductor. The value d is size of superconductor which is aligned in crystalorientation, and refers to that of each crystal grain in the case of polycrystal in which a grain boundary exists. Accordingly, "d" is impractically small when a bulk superconductor is prepared by the melting process.

It is clear from the above mentioned formula that $J_c$ and d should be increased to improve properties of bulk superconductors. As development of novel materials of higher $J_c$ is considered quite difficult, it is more practical to devise a countermeasure how to improve electromagnetic force while regarding $J_c$ is constant. That is to say, the above mentioned formula suggests that electromagnetic force can be simply improved by increasing size of superconductors even if $J_c$ is constant.

According to conventional processes for preparing bulk superconductors, however, $J_c$ tends to decrease as the size of superconductors increases. One of the reasons why is that an increase in size of superconductors makes it difficult to homogeneously distribute pinning centers.

On the other hand, it has been reported that the critical current density is improved by heavy ion or neutron irradiation to Bi-Sr-Ca-Cu-O and Y-Ba-Cu-O single crystal superconductors. This report also describes, however, that less improvement in critical current density is observed in Y-Ba-Cu-O superconductors of relatively high critical current density prepared by melting processes or thin film Y-Ba-Cu-O superconductors. It is thus hardly expected to improve critical current density of large sized crystals in a manner as described above.

RE-BCO superconductors with trapped fields in excess of 3T at 77 K after application of proton irradiation are, for example, known from Weinstein et al., Proceedings of the 10th Anniversary HTS Workshop, pp. 625-628. Details of the microstructure are not given.
The introduction of flue-pinning centers in RE-BCO sixth Superconductors is, for example, Lennon from Uleck et al., Phys. Rev. B 46 (1992), 6441-6450.

Accordingly, it is an object of the present invention to establish a means for stably providing RE-Ba-Cu-O bulk superconductors of sufficiently high electromagnetic force at relatively high temperature to improve properties of a magnet for magnetic levitation train, etc.

The inventors have eagerly investigated to achieve the above mentioned object and gained the following confidence.

Although neutron irradiation, which mass transfer rate is higher than that of heavy ion irradiation, is regarded as a greatly effective means to introduce crystalline defects as potential pinning centers into large sized bulk RE-Ba-Cu-O superconductors, remarkable improvement in critical current density is not observed in Y-Ba-Cu-O superconductors prepared by melting processes or those superconductors of thin film type according to the reported information. The reasons why are considered as in the following:

a) In a recent process for preparing superconductors, fine distribution of defects as potential pinning centers for the purpose of improving critical current density and an increase in size of oriented crystals are essentially conducted at the same time. As a result, not a few of defects are already introduced into the inside of superconductor to be irradiated by neutron, while additional defects formed by neutron irradiation function to inhibit an action of pinning centers which have been present in the superconductor.

b) In order to improve critical current density by means of neutron irradiation, there exists a tangle of various influence factors such as not only neutron exposure but composition of superconductive materials, preparing condition (temperature of melting process, etc.), structure (either single crystal or mixed phase crystal), or quality (extent of dislocation or crystal defect, etc.). However, these factors are not properly combined in conventional processes.

As a result of repeated tests in which a bulk RE-Ba-Cu-O superconductor which is aligned in crystal orientation is prepared under various conditions followed by neutron irradiation while controlling neutron exposure thereto, novel information has been obtained. There are introduced crystal defects consisting of an amorphous phrase and a recrystallized phase having a crystal orientation different from that of the parent phase which are homogeneously dispersed in oriented crystals of the bulk superconductor independent of size thereof. When size and dispersed quantity of these artificially introduced crystal defects fall in a proper range, such crystal defects exhibit a function as effective pinning centers without regard to existence of pinning centers, which are already present prior to the neutron irradiation, and neutron exposure as well as composition, preparing condition, structure, quality, etc. of a superconductive material. Finally, there can be provided a superconductor which stably exhibits high electromagnetic force and a trapped magnetic field at liquid nitrogen temperature (77K).

Further, as has been described above, fine clusters of higher RE concentration than that of the parent phase effectively function as a pinning center in RE-Ba-Cu-O superconductors wherein RE is one or more than two rare earth elements selected from La, Nd, Sm, Eu and Gd. It has been also confirmed that when superconductors comprising such clusters are subjected to neutron irradiation to properly form the above mentioned amorphous phase and recrystallized phase having a crystal orientation different from that of the parent phase, additional oxygen defects are further introduced therein by the dusters, which contribute to great improvement in critical current density and function as a factor to increase electromagnetic force and a trapped magnetic field.

According to the melting process, when a starting composition is melt-solidified, an initial composition thereof is set in advance to a $RE_2BaCuO_5$ phase (RE211 phase)-rich side, or to a $RE_4Ba_2Cu_2O_{10}$ phase (RE422

phase)-rich side in the case of RE = La or Nd, to successfully yield structure in which the RE211 or RE 422 phase is finely dispersed in a superconductive $REBa_2Cu_3O_y$ (RE123) phase, thereby forming superconductors of improved critical current density. Even in the case of such superconductors, it is found that when artificial introduction of homogeneously dispersed crystal defects under the above mentioned condition and introduction of additional oxygen defects into fine clusters of higher RE concentration than that of the parent phase are conducted by means of neutron irradiation, the critical current density thereof is improved, thereby further increasing the electromagnetic force and trapped magnetic field.

The present invention is based on the above mentioned information and other fact conformed therefrom, and provides superconductors and a method for preparing same.

1. RE-Ba-Cu-O bulk superconductors of high electromagnetic force wherein RE is one or more than two elements selected from La, Nd, Sm, Eu, Gd, Y, Ho and Dy, which comprises a parent phase with a single crystal orientation of $REBa_2CU_3O_y$ crystals wherein the diameter of the crystals is 10 mm or more and either or both of a dispersed amorphous phase and a recrystallized phase having a crystal orientation different from that of the parent phase, wherein grains in the ratio of 5 to 50 in total % by volume have a diameter of 10 to 500 nm, wherein a trapped magnetic field at liquid nitrogen temperature is over 3T.

2. RE-Ba-Cu-O bulk superconductors of high electromagnetic force wherein RE is one or more than two elements selected from La, Nd, Sm, Eu and Gd, which comprises a parent phase with a single crystal orientation of $RE_{1+x}Ba_{2-x}Cu_3O_z$ crystals wherein $0.2 < x < 0.2$ and $6.7 < z < 7.1$, and wherein the diameter of the crystals is 10 mm or more, and either or both of a dispersed amorphous phase and a recrystallized phase having a crystal orientation different from that of the parent phase in the ratio of 5 to 50 in total % by volume and a $RE_{1+x}Ba_{2-x}Cu_3O_z$ crystal phase having an oxygen concentration different from that of the parent phase with grains of 10 to 500 nm in diameter in the ratio of 5 to 15 % by volume, wherein a trapped magnetic field at liquid nitrogen temperature is over 3T.

3. Superconductors of high electromagnetic force described in the item 1 or 2 which further comprises a dispersed phase of $RE_2BaCuO_5$ crystals or $RE_4Ba_2Cu_2O_{10}$ crystals, having 20 $\mu$m or less in grain size in the ratio of not more than 40 % by volume based on a total amount thereof.

4. A method for preparing superconductors having a trapped magnetic field at liquid nitrogen temperature being over 3T described in item 1 in which neutron irradiation is applied to RE-Ba-Cu-O bulk superconductors wherein RE is one or more than two elements selected from La, Nd, Sm, Eu, Gd, Y, Ho and Dy, comprising a parent phase with a single crystal orientation of $REBa_2Cu_3O_y$ crystals, wherein the diameter of the crystals is 10 mm or more, to form a dispersed phase of either or both of amorphous phase and / or recrystallized phase having a crystal orientation different from that of the parent phase, wherein grains in the ratio of 5 to 50 in total % by volume have a diameter of 10 to 500 nm.

5. A method for preparing superconductors having a trapped magnetic field at liquid nitrogen temperature being over 3T described item 2 in which neutron irradiation is applied to RE-Ba-Cu-O superconductors wherein RE is one or more than two elements selected from La, Nd, Sm, Eu and Gd, comprising a parent phase with a single crystal orientation of $RE_{1+x}Ba_{2-x}Cu_3O_z$ crystals, wherein the diameter of the crystals is 10 mm or more, wherein $0.1 < x < 0.2$ and $6.7 < z < 7.1$ and a dispersed $RE_{1+x}Ba_{2-x}Cu_3O_z$ crystal phase having an oxygen concentration different from that of the parent phase in the ratio of 5 to 15 % by volume, to form a dispersed phase of either or both of amorphous phase and / or recrystallized phase having a crystal orientation different from that of the parent phase with grains of 10 to 500 nm in diameter in the ratio of 5 to 50 % by volume.

The most characteristic feature of the present invention is that fine defects comprising either or both of amorphous phase and / or recrystallized phase having a crystal orientation different from that of the parent phase of 10 to 500 nm in grain size in the ratio of 5 to 50 in total % by volume are artificially dispersed in a sufficiently crystal-oriented parent phase of $REBa_2Cu_3O_y$ or parent phase of $RE_{1+x}Ba_{2-x}Cu_3O_z$ wherein $0.1 < x < 0.2$ and $6.7 < z < 7.1$ of RE-Ba-Cu-O bulk superconductors by means of neutron irradiation, etc., so that these defects function effectively as pinning centers to remarkably improve critical current density, thereby providing superconductors exhibiting a greatly increased trapped magnetic field at liquid nitrogen temperature.

Further, another characteristic feature of the present invention is that RE-Ba-Cu-O superconductors are subjected to neutron irradiation, in particular, to stably prepare the above mentioned superconductors comprising either or both of amorphous phase and / or recrystallized phase having a crystal orientation different from that of the parent phase thereby greatly improving critical current density and a trapped magnetic field.

When specially qualified fine defects are introduced into RE-Ba-Cu-O bulk superconductors by means of neutron irradiation, if fine clusters comprising a $RE_{1+x}Ba_{2-x}Cu_3O_z$ crystal phase of oxygen concentration different from that of a parent phase thereof, wherein $0.1 < x < 0.2$ and $6.7 < z < 7.1$ are dispersed in the parent phase of superconductors, additional oxygen defects are further introduced into these clusters to considerably promote their function as pining centers, thereby greatly improving the critical current density in cooperation with function of the above mentioned fine defects.

Superconductors of the present invention may comprise a dispersed phase of $RE_2BaCuO_5$ crystals or $RE_4Ba_2Cu_2O_{10}$ crystals, i.e. RE211 or RE422 dispersed phase. Similarly as described above, considerable improvement in critical current density and a trapped magnetic field can also be attained by introducing either or both of amorphous phase and / or recrystallized phase having a crystal orientation different from that of the parent phase of specific grain size in a specific amount. In this case, addition of a slight amount of Pt, i.e., in an amount of 0.1 to 2 % by weight, allows the RE211 or RE422 dispersed phase in the parent phase (RE123 phase) to fine so that function thereof as pinning centers is desirably increased.

Grain size of amorphous phase or recrystallized phase having a crystal orientation different from that of the parent phase in the parent phase is limited to 10 to 500 nm according to the present invention. When the grain size is less than 10 nm, the function as pinning center is not enough to improve the critical current density and trapped magnetic field to a desired level, while the grain size over 500 nm results in poor improvement.

In addition, when the total content of these amorphous phase and recrystallized phase having a crystal orientation different from that of the parent phase" of 10 to 500 nm in grain size is less than 5 % by volume, it is impossible to attain desired critical current density and magnetic field to be captured because of insufficient function thereof as pinning centers, on the other hand, the content over 50 % by volume reduces critical temperature of superconductors, thereby superconductive properties being decreased.

Although grain size and distributed content of both phases in the parent phase may be adjusted to fall within the above mentioned range by controlling neutron exposure, preparing condition of conductive materials (temperature of melting process, etc.), structure of superconductive materials (either single crystal or mixed phase crystal), or quality (extent of dislocation or crystal defect, etc.), it is preferable to get a combination of requirements to be used by tests and surveys in advance.

With respect to neutron exposure, however, it is preferable to maintain the range of $10^{10}$ to $10^{22}$ / $m^2$ as neutron fluence in order to secure effective improvement in critical current density while keeping high superconductive properties (critical temperature) or from a standpoint of present status of atomic facilities.

Confirmation of amorphous phase and recrystallized phase having a crystal orientation different from that of the parent phase in the parent phase and determination of grain size and distributed content may be easily conducted , for example, by electron microscopy.

When superconductors of the present invention comprise a dispersed phase of $RE_2BaCuO_5$ crystals or $RE_4Ba_2Cu_2O_{10}$ crystals, grain size and content thereof are limited to 20 $\mu$m or less and 40 % by volume or less, respectively. The reason why is that effective improvement in critical current density is not obtainable if the grain size exceeds 20 $\mu$m, while the content over 40 % by volume inhibit formation of desired crystals so that critical temperature Tc is decreased.

Further, in the present RE-Ba-Cu-O bulk superconductors which comprise a parent phase of $RE_{1+x}Ba_{2-x}Cu_3O_z$ crystals wherein RE is one or more than two elements selected from La, Nd, Sm, Eu and Gd and $0.1 < x < 0.2$ $6.7 < z < 7.1$, the content of dispersed $RE_{1+x}Ba_{2-x}Cu_3O_z$ crystal phase of oxygen concentration different from that of a parent phase thereof is limited to 5 to 15 % by volume. The reason why is that the content less than 5 % by volume results in less effective improvement in critical current density, while the content more than 15 % by volume causes a decrease in critical temperature Tc.

It is preferable to keep grain size of dispersed $RE_{1+x}Ba_{2-x}Cu_3O_z$ crystal phase of oxygen concentration different from that of a parent phase thereof in the range of 3 to 50 nm to secure the function as pinning centers. Control of grain size may be conducted by adjusting atmosphere, temperature, rate, etc. of melting process.

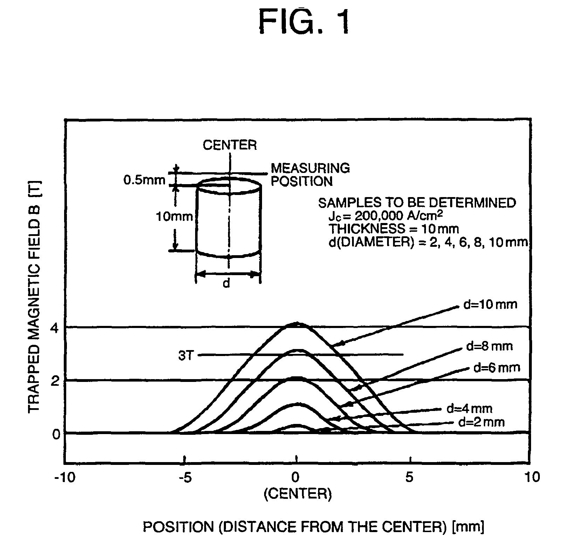

As described above, fine defects which are effective as pinning centers, i.e., an amorphous phase or recrystallized phase having a crystal orientation different from that of the parent phase, may be artificially introduced into the present RE-Ba-Cu-O bulk superconductors after bulk superconductor crystals are grown. Accordingly, it is possible to homogeneously disperse these defects in the extreme even in the case of large sized bulk superconductors. The larger the size of superconductors is, the more usefulness thereof increases. Extremely remarkable usefulness can be attained by bulk superconductors which are aligned in crystal orientation and comprise a parent phase of 10 mm or more in crystal grain size (see, Fig. 1).

Fig. 1 is a graph showing relationship between a magnetic field B to be captured and a distance from the center of samples to be evaluated. Using five kinds of present RE-Ba-Cu-O bulk superconductors having 2, 4, 6, 8 and 10 mm in diameter, 10 mm in thickness and critical current density of 200,000 A / $cm^2$ under a condition of zero magnetic field at liquid nitrogen temperature, each magnetic field B to be trapped is determined at a distance of 0.5 mm from an edge face thereof, which is an appropriate distance for determining performance of a practical permanent magnet. As shown in Fig. 1, a sample of 10 mm or more in diameter corresponding to crystal grain size of the parent phase exhibits stable magnetic field over 3 T (with sufficient flux), which greatly expands applicability thereof as a permanent magnet, etc.

According to conventional processes for preparing RE-Ba-Cu-O bulk superconductors for the purpose of improving critical current density, it has been considered that fine dispersion of defects as pinning centers and increase in size of oriented crystals should be conducted at the same time, which causes difficulty in size control of aimed superconductors as they increase their size. As a result, it is impossible to mass-produce superconductors of high critical current density and improved trapped magnetic field at high reproducibility.

By contrast, according to the present invention, an amorphous phase or recrystallized phase having a crystal orientation different from that of the parent phase can be introduced finely, homogeneously and controllably into RE123 parent phase which are sufficiently aligned in crystal orientation, for example, after large sized crystals are prepared. Accordingly, it is possible to disperse pinning centers precisely and homogeneously even in large sized bulk materials, thereby providing RE-Ba-Cu-O bulk superconductors of high critical current density and improved trapped magnetic field. High critical current density of $10^4$ to $10^5$ A / cm$^2$ or more in a magnetic field can be attained by RE-Ba-Cu-O bulk superconductors of the present invention even though they are large sized products.

Large sized crystals of RE-Ba-Cu-O bulk superconductors wherein RE is one or more than two rare earth elements selected from Y, Ho and Dy has been conventionally considered to exhibit not so high critical current density. Even in the case of such superconductors, however, critical current density over 50,000 A / cm$^2$ under a condition of zero magnetic field at relatively high temperature as liquid nitrogen temperature is obtainable by the present invention, and a higher result of 100,000 A / cm$^2$ or more can also be attained, thereby exhibiting greatly improved properties superior to properties of a permanent magnet which have been one target of superconductive materials. It is confirmed that trapped magnetic field of 1 T or more at relatively low temperature is achieved, and a level above 3 T or up to 4 T is further attainable, which is an unexpected value as superconductors and suggests applicability thereof to novel fields.

The value 3 T of trapped magnetic field has not been certainly attained by a permanent magnet even though its magnet circuit is remodeled nor even by conventional superconductors at liquid nitrogen temperature.

Further, as has been described above, fine clusters having higher RE concentration than that of the parent phase effectively function as pinning centers in RE-Ba-Cu-O bulk superconductors wherein RE is one or more than two rare earth elements selected from La, Nd, Sm, Eu and Gd. Neutron irradiation allows these clusters to introduce additional oxygen defects so that critical current density of superconductors is greatly improved to yield trapped magnetic field of 5 T or more at liquid nitrogen temperature.

It is clear from the above mentioned results that the present RE-Ba-Cu-O bulk superconductors which exhibit excellent properties at liquid nitrogen temperature can be used in the wide range of various fields including application to a magnetic levitation train in the future.

According to the present invention, large sized RE-Ba-Cu-O bulk superconductor which generate a magnetic field of 2 T or more at liquid nitrogen temperature can be easily mass-produced on an industrial scale and result in greatly useful industrial effects, superconductors of the present invention being provided to the wide range of fields including application to a magnetic levitation train in the future.

Fig. 1 is a graph showing relationship between a magnetic field B to be trapped and a distance from the center of samples to be evaluated using five kinds of RE-Ba-Cu-O bulk superconductors of different diameter.

The present invention will be further described with reference to the following examples.

Example 1

Starting powders of $Y_2O_3$, $BaCO_3$ and CuO were weighed and mixed in the ratio of Y : Ba : Cu = 1.8 : 2.4 : 3.4, followed by calcination at temperature of 900°C for 8 hours.

Then, the calcined material was further ground and mixed, and similar calcination as described above was repeated three times to form ten pellets of 3 cm in diameter and 10 cm in height.

A single crystal of Nd 123 was put on the center of each of formed pellets, heated to 1,100°C for 2 hours, and after keeping this condition for 20 minutes, cooled to 1,030°C at a cooling rate of 5°C / h, then further cooled to 900°C at a cooling rate of 0.5°C / h to solidify and grow a superconductive phase.

The pellets were subsequently subjected to an oxygen treatment by slowly cooling them in a pure oxygen flow from temperature of 600°C to 300°C over a time period of 300 hours.

After the oxygen treatment, small cubic samples of 2 mm x 2 mm x 1 mm were cut out from each pellet and subjected to determination by means of superconductive quantum interface fluxmeter. As a result, the critical temperature was 91 K, while the critical current density was 15,000 A / cm$^2$ under a condition of zero magnetic field at liquid nitrogen temperature (77 K).

On the other hand, each of oxygen treated pellets was magnetically cooled at liquid nitrogen temperature by means of a 5T-superconductive magnet and then magnetic distribution trapped by each pellet was determined using a Hall element. The trapped magnetic field of three pellets in the center thereof was 0.25, 0.28 and 0.3 T, respectively.

The above mentioned small cubic samples and three pellets were subjected to neutron irradiation under an irradiation condition of neutron fluence around $10^{21}$ / m$^2$. Critical temperature of irradiated small cubic samples was kept intact at 91 K, while critical current density thereof under a condition of zero magnetic field was improved up to 100,000 A / cm$^2$.

The trapped magnetic field of these three pellets was determined in a similar manner as described above. It was observed that their trapped magnetic field was improved to 3.3, 3.25 and 4 T, respectively.

Presence of an amorphous phase or recrystallized phase of 10 to 500 nm in grain size was confirmed by scanning microscopy of neutron irradiated samples.

As the thus confirmed defects are not observed on an unirradiated sample, it is clear that such defects are introduced into the samples through neutron irradiation.

Similar defects are observed on the top, bottom, center and periphery portions of each pellet, which shows that these defects are homogeneously dispersed throughout large sized samples.

Example 2

Starting powders of $Sm_2O_3$, $BaCO_3$ and CuO were weighed and mixed in the ratio of Sm : Ba : Cu = 1.8 : 2.4 : 3.4, followed by calcination I in an atmosphere containing 1 % oxygen at temperature of 930°C for 8 hours.

Then, the calcined material was further ground and mixed, and similar calcination as described above was repeated three times to form ten pellets of 3 cm in diameter and 10 cm in height.

Each of pellets which were formed in the 1 %-oxygen atmosphere were heated up to 1,070°C for 2 hours, and after keeping this condition for 20 minutes, cooled to 1,030°C at a cooling rate of 5°C / h, put a single crystal of Nd 123 on the center thereof, then further cooled to 900°C at a cooling rate of 0.5°C / h to solidify and grow a superconductive phase.

The pellets were subsequently subjected to an oxygen treatment by slowly cooling them in a pure oxygen flow from temperature of 600°C to 300°C over a time period of 250 hours.

After the oxygen treatment, small cubic samples of 2 mm x 2 mm x 1 mm were cut out from each pellet and subjected to determination by means of superconductive quantum interface fluxmeter. As a result, the critical temperature was 95 K, while the critical current density was 10,000 A / $cm^2$ under a condition of zero magnetic field at liquid nitrogen temperature.

On the other hand, each of oxygen treated pellets was magnetically cooled at liquid nitrogen temperature by means of a 5T-superconductive magnet and then magnetic distribution trapped by each pellet was determined using a Hall element. The trapped magnetic field of three pellets in the center thereof was 0.4, 0.5 and 0.45 T, respectively.

The above mentioned small cubic samples and three pellets were subjected to neutron irradiation under an irradiation condition of neutron fluence around $10^{20}$ / $m^2$. Critical temperature of irradiated small cubic samples was kept intact at 95 K, while critical current density thereof under a condition of zero magnetic field was improved up to 200,000 A /$cm^2$.

The trapped magnetic field of these three pellets was determined in a similar manner as described above. It was observed that their trapped magnetic field was improved to 4.9, 5.0 and 5.0 T, respectively.

As a 5 T-magnet was used as an exciter and the above mentioned values showed saturated data, much higher trapped magnetic field can be attained as a matter of fact.

Presence of an amorphous phase or recrystallized phase of 10 to 500 nm in grain size was confirmed by scanning microscopy of neutron irradiated samples.

As the thus confirmed defects are not observed on an unirradiated sample, it is clear that such defects are introduced into the samples through neutron irradiation.

Further, in addition to these defects, a region of matrix in defect of oxygen is also observed, which is anticipated to function as pinning centers. It is considered that improvement in the trapped magnetic field in this case is higher than that of Y, Ho or Dy-samples because of presence of such a region.

Similar defects are observed on the top, bottom, center and periphery portions of each pellet, which shows that these defects are homogeneously dispersed throughout large sized samples.

Example 3

Starting powders of $Nd_2O_3$, $BaCO_3$ and CuO were weighed and mixed in the ratio of Nd : Ba : Cu = 1.8 : 2.4 : 3.4, followed by calcination I in an atmosphere containing 1 % oxygen at temperature of 930°C for 8 hours.

Then, the calcined material was further ground and mixed, and similar calcination as described above was repeated three times to form ten pellets of 3 cm in diameter and 10 cm in height.

Each of pellets which were formed in the 1 %-oxygen atmosphere were heated up to 1,080°C for 2 hours, and after keeping this condition for 20 minutes, cooled to 1,040°C at a cooling rate of 5°C / h, put a single crystal of Nd 123 on the center thereof, then further cooled to 900°C at a cooling rate of 0.5°C / h to solidify and grow a superconductive phase.

The pellets were subsequently subjected to an oxygen treatment by slowly cooling them in a pure oxygen flow from temperature of 600°C to 300°C over a time period of 250 hours.

After the oxygen treatment, small cubic samples of 2 mm x 2 mm x 1 mm were cut out from each pellet and subjected to determination by means of superconductive quantum interface fluxmeter. As a result, the critical temperature was 95 K, while the critical current density was 12,000 A / $cm^2$ under a condition of zero magnetic field at liquid nitrogen temperature.

On the other hand, each of oxygen treated pellets was magnetically cooled at liquid nitrogen temperature by means of a 5T-superconductive magnet and then magnetic distribution trapped by each pellet was determined using a Hall element. The trapped magnetic field of three pellets in the center thereof was 0.55, 0.6 and 0.7 T, respectively.

The above mentioned small cubic samples and three pellets were subjected to neutron irradiation under an irradiation condition of neutron fluence around $10^{20}$ / $m^2$. Critical temperature of irradiated small cubic samples was kept intact at 96 K, while critical current density thereof under a condition of zero magnetic field was improved up to 200,000 A / $cm^2$.

The trapped magnetic field of these three pellets was determined in a similar manner as described above. It was observed that the trapped magnetic field of all samples was improved to 5 T.

As a 5 T-magnet was used as an exciter similarly as in the case of Sm-samples and the above mentioned values showed saturated data, much higher trapped magnetic field can be attained as a matter of fact.

Presence of an amorphous phase or recrystallized phase of 10 to 500 nm in grain size was confirmed by scanning microscopy of neutron irradiated samples.

As the thus confirmed defects are not observed on an unirradiated sample, it is clear that such defects are introduced into the samples through neutron irradiation.

Further, in addition to these defects, a region of matrix in defect of oxygen is also observed, which is anticipated to function as pinning centers.

Similar defects are observed on the top, bottom, center and periphery portions of each pellet, which shows that these defects are homogeneously dispersed throughout large sized samples.

Example 4

Starting powders of $Sm_2O_3$ , $BaCO_3$ and CuO were weighed, mixed in the ratio of Sm : Ba : Cu = 1.8 : 2.4 : 3.4 and then added with 0.5 % by weight of Pt, followed by calcination I in an atmosphere containing 1 % oxygen at temperature of 930°C for 8 hours.

Then, the calcined material was further ground and mixed, and similar calcination as described above was repeated three times to form ten pellets of 3 cm in diameter and 10 cm in height.

Each of pellets which were formed in the 1 %-oxygen atmosphere were heated up to 1,070°C for 2 hours, and after keeping this condition for 20 minutes, cooled to 1,030°C at a cooling rate of 5°C / h, put a single crystal of Nd 123 on the center thereof, then further cooled to 900°C at a cooling rate of 0.5°C / h to solidify and grow a superconductive phase.

The pellets were subsequently subjected to an oxygen treatment by slowly cooling them in a pure oxygen flow from temperature of 600°C to 300°C over a time period of 250 hours.

After the oxygen treatment, small cubic samples of 2 mm x 2 mm x 1 mm were cut out from each pellet and subjected to determination by means of superconductive quantum interface fluxmeter. As a result, the critical temperature was 95 K, while the critical current density was 40,000 A / $cm^2$ under a condition of zero magnetic field at liquid nitrogen temperature.

On the other hand, each of oxygen treated pellets was magnetically cooled at liquid nitrogen temperature by means of a 5T-superconductive magnet and then magnetic distribution trapped by each pellet was determined using a Hall element. The trapped magnetic field of three pellets in the center thereof was 0.6, 0.65 and 0.7 T, respectively.

The above mentioned small cubic samples and three pellets were subjected to neutron irradiation under an irradiation condition of neutron fluence around $10^{20}$ / $m^2$. Critical temperature of irradiated small cubic samples was kept intact at 95 K, while critical current density thereof under a condition of zero magnetic field was improved up to 120,000 A / $cm^2$.

The trapped magnetic field of these three pellets was determined in a similar manner as described above. It was observed that their trapped magnetic field was improved to 4.9, 5.0 and 5.0 T, respectively.

As a 5 T-magnet was used as an exciter and the above mentioned values showed saturated data, much higher trapped magnetic field can be attained as a matter of fact.

**Claims**

1. RE-Ba-Cu-O bulk superconductor, wherein RE is one or more than two elements selected from La, Nd, Sm, Eu, Gd, Y, Ho and Dy, wherein a trapped magnetic field at liquid nitrogen temperature is over 3T, **characterized by**

   - a parent phase with a single crystal orientation of $REBa_2Cu_3O_y$ crystals, wherein the diameter of the crystals is 10 mm or more, and
   - either or both of a dispersed amorphous phase and a recrystallized phase having a crystal orientation different from that of the parent phase, wherein grains in the ratio of 5 to 50 in total % by volume have a diameter of 10 to 500 nm.

2. RE-Ba-Cu-O bulk superconductor, wherein RE is one or more than two elements selected from La, Nd, Sm, Eu and Gd, wherein a trapped magnetic field at liquid nitrogen temperature is over 3T, **characterized by**

   - a parent phase with a single crystal orientation of $RE_{1+x}Ba_{2-x}Cu_3O_z$ crystals, wherein 0.1 < x < 0.2 and 6.7 < z < 7.1, and wherein the diameter of the crystals is 10 mm or more,
   - either or both of a dispersed amorphous phase and a recrystallized phase having a crystal orientation different from that of the parent phase in the ratio of 5 to 50 in total % by volume and
- a $RE_{1+x}Ba_{2-x}Cu_3O_z$ crystal phase having an oxygen concentration different from that of the parent phase with grains of 10 to 500 nm in diameter in the ratio of 5 to 15 % by volume.

3. Superconductor according to one of the preceeding claims, **characterized by** a dispersed phase of $RE_2BaCuO_5$ crystals or $RE_4Ba_2Cu_2O_{10}$ crystals, having 20 μm or less in diameter in the ratio of not more than 40 % by volume based on a total amount thereof.

4. Method for preparing the superconductor having a trapped magnetic field at liquid nitrogen temperature being over 3T according to claim 1, **characterized in that** neutron irradiation is applied to a RE-Ba-Cu-O bulk superconductor, wherein RE is one or more than two elements selected from La, Nd, Sm, Eu, Gd, Y, Ho and Dy, comprising a parent phase with a single crystal orientation of $REBa_2Cu_3O_y$ crystals, wherein the diameter of the crystals is 10 mm or more, to form a dispersed phase of either or both amorphous phase and / or recrystallized phase having a crystal orientation different from that of the parent phase, wherein grains in the ratio of 5 to 50 in total % by volume have a diameter of 10 to 500 nm.

5. A method for preparing the superconductor having a trapped magnetic field at liquid nitrogen temperature being over 3T according to claim 2, **characterized in that** neutron irradiation is applied to RE-Ba-Cu-O superconductor wherein RE is on or more than two elements selected from La, Nd, Sm, Eu, and Gd, comprising a parent phase with a single crystal orientation of $RE_{1+x}Ba_{2-x}Cu_3O_z$ crystals, wherein the diameter of the crystals is 10 mm or more, and wherein 0.1 < x < 0.2 and 6.7 < z < 7.1 and a dispersed $RE_{1+x}Ba_{2-x}Cu_3O_z$ phase having an oxygen concentration different from that of the parent phase in the ratio of 5 to 15 % by volume, to form a dispersed phase of either or both amorphous phase and / or recrystallized phase having a crystal orientation different from that of the parent phase with grains of 10 to 500 nm in diameter in the ratio of 5 to 50 % by volume.

**Patentansprüche**

1. RE-Ba-Cu-O Massivsupraleiter, wobei RE ein Element oder mehr als zwei Elemente ist, ausgewählt aus La, Nd, Sm, Eu, Gd, Y, Ho und Dy, wobei ein eingeschlossenes Magnetfeld bei einer Temperatur von flüssigem Stickstoff über 3T ist, **gekennzeichnet durch**

- eine Ausgangsphase mit einer einzigen Kristallorientierung von $REBa_2CU_3O_y$ Kristallen, wobei der Durchmesser der Kristalle 10 mm oder mehr ist, und
- eine dispergierte amorphe Phase und/oder eine rekristallisierte Phase mit einer Kristallorientierung, die verschieden von der der Ausgangsphase ist, wobei Körner in einem Verhältnis von insgesamt 5 bis 50 Vol.-% einen Durchmesser von 10 bis 500 nm haben.

2. RE-Ba-Cu-O Massivsupraleiter, wobei RE ein Element oder mehr als zwei Elemente ist, ausgewählt aus La, Nd, Sm, Eu und Gd, wobei ein eingeschlossenes Magnetfeld bei einer Temperatur von flüssigem Stickstoff über 3T ist, **gekennzeichnet durch**

- eine Ausgangsphase mit einer einzigen Kristallorientierung von $RE_{1+x}Ba_{2-x}Cu_3O_z$ Kristallen, wobei 0,1 < x < 0,2 und 6,7 < z < 7,1 ist und wobei der Durchmesser der Kristalle 10 mm oder mehr ist, und
- eine dispergierte amorphe Phase und/oder eine rekristallisierte Phase mit einer von der Ausgangsphase verschiedenen Kristallorientierung im Verhältnis von insgesamt 5 bis 50 Vol.-% und
- eine $RE_{1+x}Ba_{2-x}Cu_3O_z$ Kristallphase mit einer von der Ausgangsphase verschiedenen Sauerstoffkonzentration mit Körnern mit einem Durchmesser von 10 bis 500 nm im Verhältnis von 5 bis 15 Vol.-%.

3. Supraleiter nach einem der vorhergehenden Ansprüche, **gekennzeichnet durch** eine dispergierte Phase aus $RE_2BaCuO_5$ Kristallen oder $RE_4Ba_2Cu_2O_{10}$ Kristallen, mit einem Durchmesser von 20 μm oder weniger im Verhältnis von nicht mehr als 40 Vol.-% basierend auf deren Gesamtgehalt.

4. Verfahren zum Herrichten des Supraleiters mit einem eingeschlossenen Magnetfeld bei einer Temperatur von flüssigem Stickstoff von über 3T nach Anspruch 1, **dadurch gekennzeichnet, dass** Neutronenstrahlung auf den RE-Ba-Cu-O Massivsupraleiter angewendet wird, wobei RE ein Element oder mehr als zwei Elemente ist, ausgewählt aus La, Nd, Sm, Eu, Gd, Y, Ho und Dy, umfassend eine Ausgangsphase mit einer einzigen Kristallorientierung von $REBa_2Cu_3O_y$ Kristallen, wobei der Durchmesser der Kristalle 10 mm oder mehr ist, um eine dispergierte Phase einer amorphen Phase und/oder einer rekristallisierten Phase mit einer von der Ausgangsphase verschiedenen Kristallorientierung zu bilden, wobei Körner im Verhältnis von insgesamt 5 bis 50 Vol.-% einen Durchmesser von 10 bis 500 nm haben.

5. Verfahren zum Herrichten eines Supraleiters mit einem eingeschlossenen Magnetfeld bei einer Temperatur von flüssigem Stickstoff von über 3T nach Anspruch 2,
**dadurch gekennzeichnet, dass**
Neutronenstrahlung auf den RE-Ba-Cu-O Massivsupraleiter angewendet wird, wobei RE ein Element oder mehr als zwei Elemente ist, ausgewählt aus La, Nd, Sm, Eu und Gd, umfassend eine Ausgangsphase mit einer einzigen Kristallorientierung von $RE_{1+x}Ba_{2-x}Cu_3O_z$ Kristallen, wobei der Durchmesser der Kristalle 10 mm oder mehr ist, und wobei $0,1 < x < 0,2$ und $6,7 < z < 7,1$ ist, und eine dispergierte $RE_{1+x}Ba_{2-x}Cu_3O_z$ Phase mit einer von der Ausgangsphase verschiedenen Sauerstoffkonzentration im Verhältnis von 5 bis 15 Vol.%, um eine dispergierte Phase einer amorphen Phase und/oder einer rekristallisierten Phase mit einer von der Ausgangsphase verschiedenen Kristallorientierung zu bilden, mit Körnern mit einem Durchmesser von 10 bis 500 nm im Verhältnis von 5 bis 50 Vol.-%.

## Revendications

1. Supraconducteur en vrac RE-Ba-Cu-O, dans lequel RE est l'un ou plus que deux éléments sélectionnés à partir de La, Nd, Sm, Eu, Gd, Y, Ho et Dy, dans lequel un champ magnétique piégé à la température de l'azote liquide se situe au-delà de 3T, **caractérisé par**

   - une phase parente ayant une orientation cristalline unique des cristaux $REBa_2Cu_3O_y$, dans laquelle le diamètre des cristaux est de 10 mm ou plus, et
   - une ou les deux d'une phase amorphe dispersée et d'une phase recristallisée ayant une orientation cristalline différente de celle de la phase parente, dans laquelle/lesquelles les grains selon un rapport de 5 à 50 en pourcentage total par volume ont un diamètre de 10 à 500 nm.

2. Supraconducteur en vrac RE-BA-CU-O, dans lequel RE et l'un ou plus que deux éléments sélectionnés à partir de La, Nd, Sm, Eu et Gd, dans lequel un champ magnétique piégé à la température de l'azote liquide se situe au-delà de 3T, **caractérisé par**

   - une phase parente ayant une orientation cristalline unique des cristaux $RE_{1+x}Ba_{2-x}Cu_3O_2$, dans laquelle $0,1 < x < 0,2$ et $6,7 < z < 7,1$ et dans laquelle le diamètre des cristaux est de 10 mm ou plus,

   - une ou les deux d'une phase amorphe dispersée et d'une phase recristallisée ayant une orientation cristalline différente de celle de la phase parente selon le rapport de 5 à 50 en pourcentage total par volume et
   - une phase cristalline $RE_{1+x}Ba_{2-x}Cu_3O_2$ ayant une concentration en oxygène différente de celle de la phase parente avec des grains de 10 à 500 nm de diamètre selon le rapport de 5 à 15% par volume.

   dans lesquelles un champ magnétique piégé à la température de l'azote liquide se situe au-delà de 3T,

3. Supraconducteur selon l'une des revendications précédentes, **caractérisé par** une phase dispersée de cristaux $RE_2BaCuO_5$ ou de cristaux $RE_4Ba_2Cu_2O_{10}$, ayant un diamètre de 20 $\mu m$ ou moins selon le rapport de pas plus de 40% par volume basé sur une quantité totale de celui-ci.

4. Méthode de préparation du supraconducteur ayant un champ magnétique piégé à la température de l'azote liquide au-delà de 3T selon la revendication 1, **caractérisée en ce que**
   une irradiation de radium est appliquée au supraconducteur en vrac RE-Ba-Cu-O, dans lequel RE est un ou plus que deux éléments sélectionnés à partir de La, Nd, Sm, Eu, Gd, Y, Ho et Dy, comprenant une phase parente avec une orientation cristalline unique des cristaux $REBa_2Cu_3O_y$, dans laquelle le diamètre des cristaux est de 10 mm ou plus, de manière à former une phase dispersée de l'une ou des deux phases amorphes et / ou une phase recristallisée ayant une orientation cristalline différente de celle de la phase parente, dans laquelle des grains selon le rapport de 5 à 50 en pourcentage total par volume ont un diamètre de 10 à 500 nm.

5. Méthode de préparation du supraconducteur ayant un champ magnétique piégé à la température de l'azote liquide se situant au-delà de 3T selon la revendication 2, **caractérisée en ce qu'**une irradiation avec des neutrons est appliquée au supraconducteur RE-Ba-Cu-O dans laquelle RE est un ou plus que deux éléments sélectionnés à partir de La, Nd, Sm, Eu et Gd comprenant une phase parente avec une orientation cristalline unique des cristaux $RE_{1+x}Ba_{2-x}Cu_3O_2$, dans laquelle le diamètre des cristaux est de 10 mm ou plus et dans laquelle $0,1 < x < 0,2$ et $6,7 < z < 7,1$ et une phase dispersée de $RE_{1+x}Ba_{2-x}Cu_3O_2$ ayant une concentration différente de celle de la phase parente selon le rapport de 5 à 15% par volume, pour former une phase dispersée de l'une ou des deux phases amorphes et / ou de la phase recristallisée ayant une orientation cristalline différente de la phase parente avec des grains de 10 à 500 nm de diamètre selon un rapport de 5 à 50% par volume.

# FIG. 1

CENTER

MEASURING
POSITION

0.5mm

10mm

d

SAMPLES TO BE DETERMINED
$J_c$ = 200,000 A/cm$^2$
THICKNESS = 10mm
d(DIAMETER) = 2, 4, 6, 8, 10mm

TRAPPED MAGNETIC FIELD B [T]

d=10mm

3T

d=8mm

d=6mm

d=4mm

d=2mm

4

2

0

-10    -5    0    5    10
(CENTER)

POSITION (DISTANCE FROM THE CENTER) [mm]

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **WEINSTEIN et al.** *Proceedings of the 10th Anniversary HTS Workshop,* 625-628

- **ULECK et al.** *Phys. Rev. B,* 1992, vol. 46, 6441-6450